# EUROPEAN PATENT APPLICATION

(11) **EP 4 764 549 A1**
(43) Date of publication of application: **24.06.2026**
(21) Application number: 25833509.0
(22) Date of filing: 04.07.2025
(51) Int. Cl.: G01R 31/392, G01R 31/396, G01R 31/367, G01R 31/3842, H02J 7/00

(54) **BATTERY DIAGNOSTIC DEVICE AND METHOD THEREFOR**

(30) Priority: 05.07.2024 KR 20240089210
(71) Applicant: LG Energy Solution, Ltd., Seoul 07335 (KR)
(72) Inventor: KIM, Eung Yong, Daejeon 34122 (KR)
(74) Representative: Plasseraud IP
(86) International application number: PCT/KR2025/009591
(87) International publication number: WO 2026/010423

(57) **Abstract**

A battery diagnosis device according to an embodiment of this document includes a memory configured to store at least one instruction and at least one processor configured to execute the at least one instruction, and the one or more processors may be configured to identify a degradation indicator for each charging capacity of a first battery cell among a plurality of battery cells included in a battery unit, identify a degradation indicator of a second battery cell based on at least one of a value of a charging capacity of a second battery cell among the plurality of battery cells, a degradation indicator for each charging capacity of the first battery cell, or a combination thereof, and diagnose a state of the second battery cell based on the degradation indicator of the second battery cell.

## Description

### TECHNICAL FIELD

### Cross-reference to Related Applications

This application claims priority from Korean Patent Application No. 10-2024-0089210, filed on July 5, 2024, the disclosure of which is incorporated by reference herein.

### Technical Field

Embodiments disclosed in this document relate to a battery diagnosis device and battery diagnosis method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

With the proliferation of electronic devices due to the Fourth Industrial Revolution, battery usage is increasing dramatically. Batteries are in the spotlight as an essential energy source in various applications, such as electric vehicles, portable electronic devices, and renewable energy storage systems, and accordingly, the importance of technology for diagnosing a battery state to improve battery performance and reliability is increasing.

In particular, a technology for identifying a degradation indicator of each of battery cells within a battery unit indicating a degradation degree of each of the battery cells is being developed. By identifying the degradation indicator of each of the battery cells, the performance of battery state diagnosis of the battery diagnosis device may be improved. Through the improved battery state diagnosis, extension and performance optimization can be realized, and stability can be ensured by detecting unexpected errors.

### DISCLOSURE OF THE INVENTION

### TECHNICAL PROBLEM

Embodiments provide a battery diagnosis device and battery diagnosis method that extend the life of battery cells by acquiring a degradation indicator of each of battery cells included in a battery unit.

Embodiments provide a battery diagnosis device and battery diagnosis method that contribute to improve the stability of battery cells by acquiring a degradation indicator of each of battery cells included in a battery unit.

Embodiments provide a battery diagnosis device and battery diagnosis method that improve the accuracy of state diagnosis of battery cells by acquiring a degradation indicator of each of battery cells included in a battery unit.

Embodiments provide a battery diagnosis device and battery diagnosis method that acquire degradation indicators of a plurality of battery cells by identifying a degradation indicator of each of a plurality of battery cells included in a battery unit according to a degradation indicator of the battery unit and a charging capacity of each of the plurality of battery cells.

Embodiments provide a battery diagnosis device and battery diagnosis method that reduce temporal resources required for battery diagnosis by identifying a degradation indicator of each of a plurality of battery cells included in a battery unit according to a degradation indicator of the battery unit and a charging capacity of each of the plurality of battery cells.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery diagnosis device according to an embodiment of this document includes a memory configured to store at least one instruction and one or more processors configured to execute the at least one instruction.

According to an embodiment, the one or more processors may be configured to identify a degradation indicator for each charging capacity of a first battery cell among a plurality of battery cells included in a battery unit, identify a degradation indicator of a second battery cell based on at least one of a value of a charging capacity of a second battery cell among the plurality of battery cells, a degradation indicator for each charging capacity of the first battery cell, or a combination thereof, and diagnose a state of the second battery cell based on the degradation indicator of the second battery cell.

According to an embodiment, the one or more processors may be configured to identify a value of the degradation indicator of the second battery cell based on a specific value of the degradation indicator of the first battery cell corresponding to the value of the charging capacity of the second battery cell in the degradation indicator for each charging capacity of the first battery cell.

According to an embodiment, the first battery cell may include a battery cell corresponding to the smallest charging capacity among charging capacities of the plurality of battery cells.

According to an embodiment, a charging capacity of each of the plurality of batteries may be identified for each battery cell included in the plurality of battery cells based on the number of times of charging and discharging of the battery unit.

According to an embodiment, the charging capacity of each of the plurality of batteries may include a charging capacity according to a state of health (SOH) of each of the plurality of battery cells identified based on the number of times of charging and discharging of the battery unit.

According to an embodiment, the one or more processors may be configured to identify the degradation indicator for each charging capacity of the first battery cell based on a constant voltage (CV) charging time, which indicates a duration of a section during which a voltage of the battery unit is held constant during charging or discharging.

According to an embodiment, the battery unit may be charged according to a constant current (CC) until a voltage of at least one battery cell among the plurality of battery cells included in the battery unit reaches a reference voltage value, and the one or more processors may be configured to identify the degradation indicator for each charging capacity of the first battery cell based on the fact that the battery unit is charged according to a constant voltage until a current of at least one battery cell among the plurality of battery cells reaches a reference current value after the voltage reaches the reference voltage value.

A battery diagnosis method according to an embodiment of this document includes an operation of identifying a degradation indicator for each charging capacity of a first battery cell among a plurality of battery cells included in a battery unit, an operation of identifying a degradation indicator of a second battery cell based on at least one of a value of a charging capacity of a second battery cell among the plurality of battery cells, a degradation indicator for each charging capacity of the first battery cell, or a combination thereof, and an operation of diagnosing a state of the second battery cell based on the degradation indicator of the second battery cell.

According to an embodiment, the operation of identifying a degradation indicator of a second battery cell based on at least one of a value of a charging capacity of a second battery cell among the plurality of battery cells, a degradation indicator for each charging capacity of the first battery cell, or a combination thereof may further include an operation of identifying a value of the degradation indicator of the second battery cell based on a specific value of the degradation indicator of the first battery cell corresponding to the value of the charging capacity of the second battery cell in the degradation indicator for each charging capacity of the first battery cell.

According to an embodiment, the first battery cell may include a battery cell corresponding to the smallest charging capacity among charging capacities of the plurality of battery cells.

According to an embodiment, a charging capacity of each of the plurality of batteries may be identified for each battery cell included in the plurality of battery cells based on the number of times of charging and discharging of the battery unit.

According to an embodiment, the charging capacity of each of the plurality of batteries may include a charging capacity according to a state of health (SOH) of each of the plurality of battery cells identified based on the number of times of charging and discharging of the battery unit.

According to an embodiment, the battery diagnosis method may further include an operation of identifying the degradation indicator for each charging capacity of the first battery cell based on a constant voltage (CV) charging time, which indicates a duration of a section during which a voltage of the battery unit is held constant during charging or discharging.

According to an embodiment, after the battery unit is charged according to a constant current (CC) until a voltage of at least one battery cell among the plurality of battery cells included in the battery unit reaches a reference voltage value, the operation of identifying a degradation indicator for each charging capacity of a first battery cell among a plurality of battery cells included in a battery unit may include an operation of identifying the degradation indicator for each charging capacity of the first battery cell based on the fact that the battery unit is charged according to a constant voltage until a current of at least one battery cell among the plurality of battery cells reaches a reference current value after the voltage reaches the reference voltage value.

### ADVANTAGEOUS EFFECTS

The present technology can extend the life of battery cells by acquiring a degradation indicator of each of battery cells included in a battery unit.

In addition, the present technology can contribute to improve the stability of battery cells by acquiring a degradation indicator of each of battery cells included in a battery unit.

In addition, the present technology can improve the accuracy of state diagnosis of battery cells by acquiring a degradation indicator of each of battery cells included in a battery unit.

In addition, the present technology can acquire degradation indicators of a plurality of battery cells by identifying a degradation indicator of each of a plurality of battery cells included in a battery unit according to a degradation indicator of the battery unit and a charging capacity of each of the plurality of battery cells.

In addition, the present technology can reduce temporal resources required for battery diagnosis by identifying a degradation indicator of each of a plurality of battery cells included in a battery unit according to a degradation indicator of the battery unit and a charging capacity of each of the plurality of battery cells.

In addition, various effects directly or indirectly identified through this document may be provided.

### BRIEF DESCRIPTION OF THE DRAWINGS

FIG. 1 is a block diagram illustrating a battery pack, in a battery diagnosis device and battery diagnosis method according to an embodiment of this document.
FIG. 2 is a block diagram illustrating a configuration of a battery diagnosis device, in a battery diagnosis device and battery diagnosis method according to an embodiment of this document.
FIG. 3 illustrates an example of a graph indicating a charging capacity and a degradation indicator, in a battery diagnosis device and battery diagnosis method according to an embodiment of this document.
FIG. 4 illustrates an example of a table indicating degradation indicators for each charging capacity, in a battery diagnosis device and battery diagnosis method according to an embodiment of this document.
FIG. 5 illustrates an example of a flow of operations of a battery diagnosis device for diagnosing a state of a second battery cell, in a battery diagnosis device and battery diagnosis method according to an embodiment of this document.
FIG. 6 is a block diagram illustrating a hardware configuration of a computing system that performs a battery diagnosis method, in a battery diagnosis device and battery diagnosis method according to an embodiment of this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

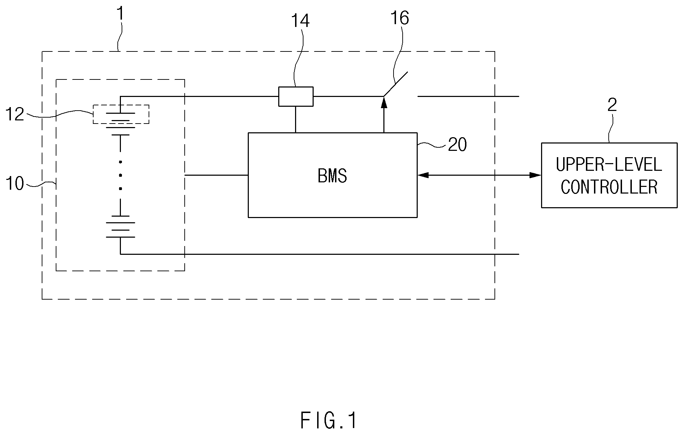

Hereinafter, embodiments of this document will be described in detail with reference to FIGS. 1 to 6.

FIG. 1 is a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV) or an energy storage system (ESS).

According to an embodiment, the battery unit 12 may include at least one battery unit 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

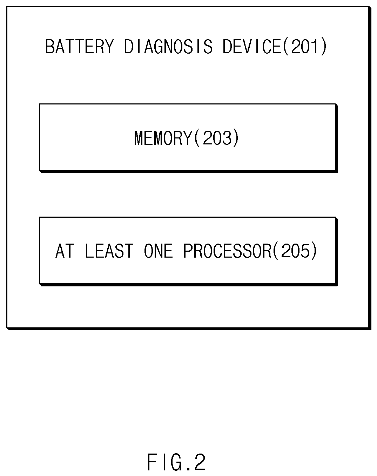

According to an embodiment, the battery management system 20 may include a battery diagnosis device 201 of FIG. 2. According to another embodiment, the battery management system 20 may be a different system from the battery diagnosis device 201 of FIG. 2. That is, the battery diagnosis device 201 of FIG. 2 may be included in the battery pack 1 or may be configured as another device external to the battery pack 1. Hereinafter, for convenience of description, the description will be made on the assumption that the battery diagnosis device 201 is composed of another device external to the battery pack 1. In addition, the operation of the battery diagnosis device 201 described below may be performed by a BMS in the vehicle, and may also be performed by various devices such as a server, a cloud, a charger, or a discharger.

FIG. 2 is a block diagram showing the configuration of a battery diagnosis device, in a battery diagnosis device and battery diagnosis method according to an embodiment of this document.

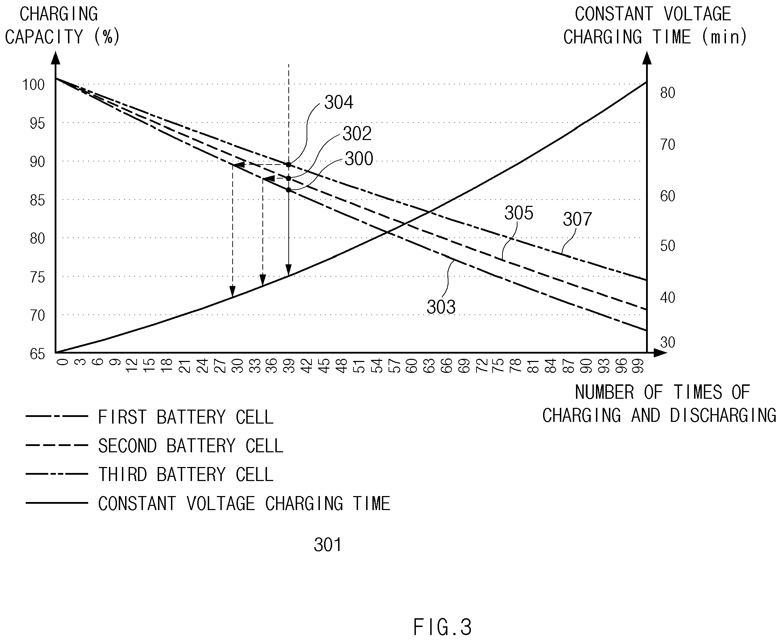

FIG. 3 illustrates an example of a graph representing a charging capacity and a degradation indicator, in a battery diagnosis device and battery diagnosis method according to an embodiment of this document.

Referring to FIGS. 2 and 3, a battery diagnosis device 201 may include a memory 203 and one or more processors 205. The memory 203 may store at least one instruction. The one or more processors 205 may execute at least one instruction.

A first line 303 included in the graph 301 may represent the charging capacity according to the number of times of charging and discharging of the first battery cell corresponding to the smallest charging capacity among the charging capacities of a plurality of battery cells included in a battery unit. A second line 305 included in the graph 301 may represent the charging capacity according to the number of times of charging and discharging of a second battery cell, which indicates one of the plurality of battery cells included in the battery unit. A third line 307 included in the graph 301 may represent the charging capacity according to the number of times of charging and discharging of a third battery cell, which indicates another battery cell among a plurality of battery cells included in the battery unit.

A first point 300 may represent the charging capacity and the number of times of charging and discharging of the first battery cell at a specific point in time. A second point 302 may represent the charging capacity and the number of times of charging and of the second battery cell at a specific point in time. A third point 304 may represent the charging capacity and the number of times of charging and discharging of the third battery cell at a specific point in time.

According to an embodiment, the processor 205 of the battery diagnosis device 201 may identify a degradation indicator (e.g., constant voltage charging time) of a battery unit (e.g., a battery module, a battery pack, and a battery).

Hereinafter, FIG. 3 describes the constant voltage charging time which is an example of the degradation indicator, but the embodiments of this document may not be limited thereto. A degradation indicator according to an embodiment may indicates a degradation indicator when a degradation indicator of each of a plurality of battery cells included in a battery unit is not identified and only the overall degradation indicator of the battery unit is identified.

According to an embodiment, when the degradation indicator of each of the plurality of battery cells included in the battery unit is not identified and only the overall degradation indicator of the battery unit is identified, the degradation indicator of the battery unit may not reflect the degree of degradation of each battery cell.

For example, when the degradation indicator is the constant voltage charging time, the degradation indicator of the battery unit may be determined based on a measured value of a battery cell corresponding to the smallest charging capacity among charging capacities of the plurality of battery cells.

The charging capacity may indicates a charging capacity according to the state of health (SOH) of each of the plurality of battery cells, which is identified based on the number of times of charging and discharging of the battery unit. The battery cell corresponding to the smallest charging capacity among the charging capacities of the plurality of battery cells may indicates the battery cell that has undergone the most degradation among the plurality of battery cells.

According to an embodiment, one or more processors 205 of the battery diagnosis device 201 may not identify the degradation indicator of each of the plurality of battery cells included in the battery unit, but may identify the charging capacity of each of the plurality of battery cells included in the battery unit.

According to an embodiment, one or more processors 205 of the battery diagnosis device 201 may identify the degradation indicator of each of the plurality of battery cells based on the charging capacity of each of the plurality of battery cells and the degradation indicator for each charging capacity of the first battery cell, which has undergone the most degradation among the plurality of battery cells. This is because the charging capacity of any one battery cell included in the plurality of battery cells is correlated with the degradation indicator.

For example, when the degradation indicator is the constant voltage charging time, the relationship between charging capacity of a battery cell and the constant voltage charging time of the battery cell may be such that as the charging capacity of the battery cell decreases, the constant voltage charging time increases.

This is because the relationship between the charging capacity of a battery cell and the number of times of charging and discharging of the battery cell may be such that as the number of times of charging and discharging of the battery cell increases, the charging capacity of the battery cell decreases, and the relationship between the constant voltage charging time of the battery cell and the number of times of charging and discharging of the battery cell may be such that as the number of times of charging and discharging of the battery cell increases, the charging capacity of the battery cell increases.

According to an embodiment, one or more processors 205 of the battery diagnosis device 201 may identify the degradation indicator of the battery unit. The degradation indicator of the battery unit may be identified as the degradation indicator of the first battery cell corresponding to the smallest charging capacity among the plurality of battery cells included in the battery unit.

According to an embodiment, one or more processors 205 of the battery diagnosis device 201 may identify the charging capacity of the first battery cell at a specific point in time (e.g., the charging capacity at the first point 300, which is approximately 86%), the charging capacity of a second battery cell (e.g., the charging capacity at the second point 302, which is approximately 88%), and the charging capacity of a third battery cell (e.g., charging capacity at the third point 304, which is approximately 90%).

According to an embodiment, one or more processors 205 of the battery diagnosis device 201 may immediately identify the degradation indicator of each of the plurality of battery cells based on the degradation indicator for each charging capacity of the entire battery unit and the charging capacity of each of the plurality of battery cells (e.g., the first battery cell, the second battery cell, and the third battery cell). However, in the following, in order to explain the relationship between the charging capacity and the constant voltage charging time, it will be described that the number of times of charging and discharging is identified based on the charging capacity, and the constant voltage charging time is identified based on the number of times of charging and discharging.

According to an embodiment, a charging process of a battery unit may include a constant current (CC) charging section and a constant voltage (CV) charging section. In the constant current charging section, the battery unit may be charged with a current having a constant magnitude until a voltage of at least one battery cell among a plurality of battery cells included in the battery unit reaches a reference voltage value.

After the voltage of at least one battery cell among the plurality of battery cells reaches the reference voltage value, the battery unit may be charged with a voltage having a constant magnitude value until the current of at least one battery cell among the plurality of battery cells included in the battery unit reaches a reference current value.

The time from the point in time at which the voltage of at least one battery cell among the plurality of battery cells reaches the reference voltage to the point in time at which the current of at least one battery cell among the plurality of battery cells reaches the reference current value may be referred to as the constant voltage charging time.

The constant voltage charging time may indicate the duration of a section during which the voltage of the battery unit is held constant during charging or discharging. The constant voltage charging time increases as the number of times of charging and discharging of the battery unit increases, and thus may be used as the degradation indicator. This is because as the number of times of charging and discharging of the battery unit increases, the resistance of the battery cells included in the battery unit increases, and as the resistance of the battery cells increases, the time until the reference current is reached increases.

For example, since the constant voltage charging time is the time until the current of at least one battery cell among the plurality of battery cells reaches the reference current value, the constant voltage charging time may be identified based on whether the current of the battery cell that corresponds to the smallest charging capacity among the charging capacities of the plurality of battery cells and has undergone the most degradation among the plurality of battery cells reaches the reference current value.

According to an embodiment, one or more processors 205 of the battery diagnosis device 201 may identify the constant voltage charging time of a battery unit as the constant voltage charging time of the first battery cell (e.g., approximately 47 minutes). This is because the constant voltage charging time is identified based on the battery cell corresponding to the smallest charging capacity among the charging capacities of the battery cells included in the battery unit.

According to an embodiment, one or more processors 205 of the battery diagnosis device 201 may identify a constant voltage charging time corresponding to the charging capacity (e.g., the charging capacity corresponding to the second point 302 and the charging capacity corresponding to the third point 304) of a specific battery cell (e.g., a second battery cell and a third battery cell) at a specific point in time, based on the constant voltage charging time for each charging capacity of the first battery cell.

For example, one or more processors 205 of the battery diagnosis device 201 may identify the number of times of charging and discharging corresponding to the charging capacity (e.g., the charging capacity corresponding to the second point 302) of the second battery cell at a specific point in time (e.g., the number of times of charging and discharging corresponding to the second point 302). One or more processors 205 of the battery diagnosis device 201 may identify a constant voltage charging time corresponding to the number of times of charging and discharging of the second battery cell at a specific point in time (e.g., the number of times of charging and discharging corresponding to the second point 302), based on the charging capacity (e.g., the content indicated by the first line 303) corresponding to the number of times of charging and discharging of the first battery cell.

For example, one or more processors 205 of the battery diagnosis device 201 may identify the number of times of charging and discharging corresponding to the charging capacity (e.g., the charging capacity corresponding to the third point 304) of the third battery cell at a specific point in time (e.g., the number of times of charging and discharging corresponding to the third point 304). One or more processors 205 of the battery diagnosis device 201 may identify a constant voltage charging time corresponding to the number of times of charging and discharging of the third battery cell at a specific point in time (e.g., the number of times of charging and discharging corresponding to the third point 304), based on the charging capacity (e.g., the content indicated by the first line 303) corresponding to the number of times of charging and discharging of the first battery cell.

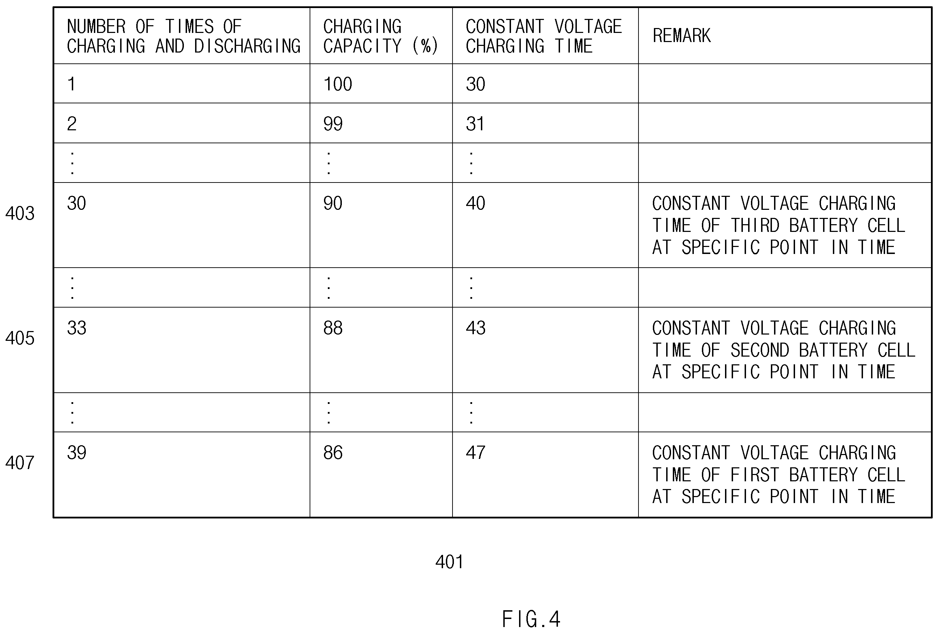

FIG. 4 illustrates an example of a table indicating degradation indicators for each charging capacity, in a battery diagnosis device and battery diagnosis method according to an embodiment of this document.

Referring to FIG. 4, a table 401 may include content corresponding to the graph 301 of FIG. 3. The table 401 may indicate the charging capacity of a first battery cell corresponding to the number of times of charging and discharging of the first battery cell, and the constant voltage charging time of the first battery cell corresponding to the number of times of charging and discharging of the first battery cell. A first row 403 may indicate the number of times of charging and discharging and the constant voltage charging time of the first battery cell when the charging capacity of the first battery cell is approximately 90%. A second row 405 may indicate the number of times of charging and discharging and the constant voltage charging time of the first battery cell when the charging capacity of the first battery cell is approximately 88%. A third row 407 may represent the number of times of charging and discharging and the constant voltage charging time of the first battery cell when the charging capacity of the first battery cell is approximately 86%.

According to an embodiment, the constant voltage charging time of the battery unit at a specific point in time may indicates the constant voltage charging time of the first battery cell at a specific point in time (e.g., the constant voltage charging time of the third row 407).

This is because the constant voltage charging time is the time until the current of at least one battery cell among the plurality of battery cells reaches the reference current value. Therefore, the constant voltage charge time can be identified based on whether the current of the battery cell that corresponds to the smallest charging capacity among the charging capacities of the plurality of battery cells and has undergone the most degradation among the plurality of battery cells reaches the reference current value.

According to an embodiment, one or more processors 205 of the battery diagnosis device 201 may store a constant voltage charging time according to the charging capacity of the first battery cell, as shown in Table 401. For example, one or more processors 205 of the battery diagnosis device 201 may store content regarding the constant voltage charging time when the charging capacity of the first battery cell is approximately 88% and the constant voltage charging time when the charging capacity of the first battery cell is approximately 90%.

According to an embodiment, one or more processors 205 of the battery diagnosis device 201 may identify the charging capacity of the second battery cell and the charging capacity of the third battery cell at a specific point in time.

For example, when the charging capacity of the second battery cell at a specific point in time is approximately 88%, one or more processors 205 of the battery diagnosis device 201 may identify the constant voltage charging time of the second battery cell at the specific point in time as the constant voltage charging time (e.g., approximately 43 minutes) when the charging capacity of the first battery cell is approximately 88%.

For example, when the charging capacity of the third battery cell at a specific point in time is approximately 90%, one or more processors 205 of the battery diagnosis device 201 may identify the constant voltage charging time of the second battery cell at the specific point in time as the constant voltage charging time (e.g., approximately 40 minutes) when the charging capacity of the first battery cell is approximately 90%.

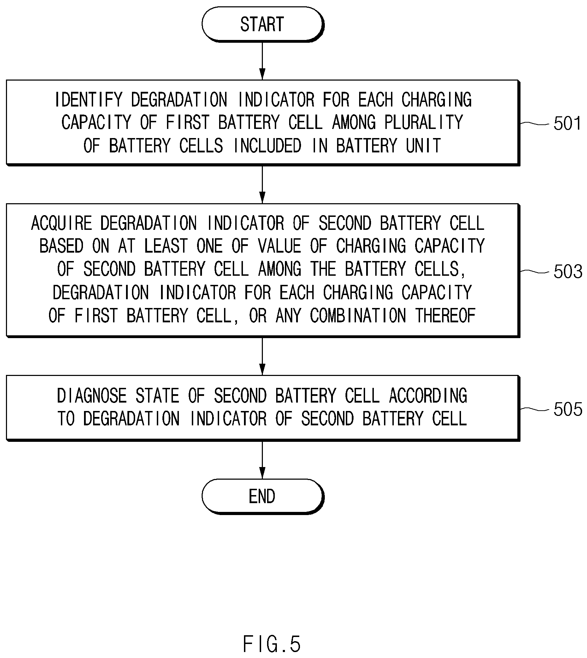

FIG. 5 illustrates an example of a flow of operations of a battery diagnosis device for diagnosing a state of a second battery cell, in a battery diagnosis device and battery diagnostic method according to an embodiment of this document.

Referring to FIG. 5, in a first operation 501, at least one processor 205 of the battery diagnosis device 201 according to an embodiment may identify a degradation indicator for each charging capacity of a first battery cell among a plurality of battery cells included in a battery unit.

In a second operation 503, at least one processor 205 of the battery diagnosis device 201 according to an embodiment may acquire a degradation indicator of a second battery cell based on at least one of a value of a charging capacity of a second battery cell among the battery cells, a degradation indicator for each charging capacity of the first battery cell, or any combination thereof.

In a third operation 505, at least one processor 205 of the battery diagnosis device 201 according to an embodiment may diagnose a state of the second battery cell according to the degradation indicator of the second battery cell.

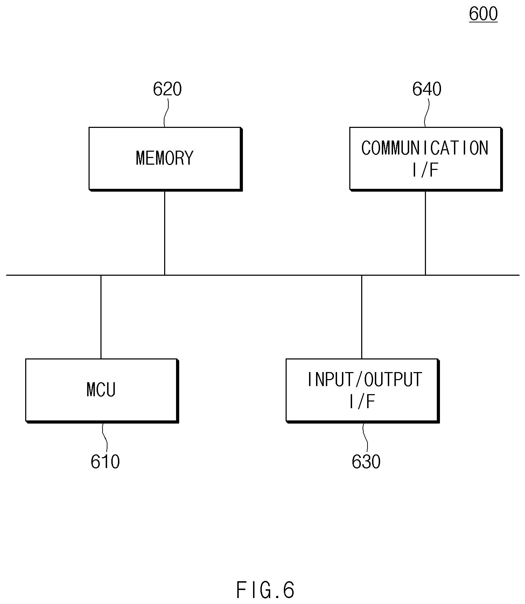

FIG. 6 is a block diagram illustrating a hardware configuration of a computing system that performs a battery diagnosis method, in a battery diagnosis device and battery diagnosis method according to an embodiment of this document.

Referring to FIG. 6, a computing system 600 according to an embodiment disclosed in this document may include an MCU 610, a memory 620, an input/output I/F 630, and a communication I/F 640.

The MCU 610 may be one or more processors that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 201 shown in FIGS. 2 to 5 described above.

The memory 620 may store various programs such as the battery cell data collection program, the graph generation program, the data analysis program, the data decomposition algorithm, the normalization program, and the battery cell diagnosis program.

A plurality of such memories 620 may be provided as needed. The memory 620 may be a volatile memory or a nonvolatile memory. The memory 620 used as the volatile memory may be RAM, DRAM, SRAM, etc. The memory 620 used as the nonvolatile memory may be ROM, PROM, EAROM, EPROM, EEPROM, flash memory, etc. The examples of the memories 620 listed above are only examples, but are not limited to these examples.

The input/output I/F 630 may provide an interface that allows data to be transmitted and received by connecting an input device (not shown) such as a keyboard, mouse, or touch panel and an output device (not shown) such as a display with the MCU 610.

The communication I/F 640 is a configuration that can transmit and receive various data with the server, and may be various devices that can support wired or wireless communication. For example, the battery diagnosis device 201 may transmit and receive various information including shape models of battery cells, etc. to and from a separately provided external server through the communication I/F 640.

In this way, the computer program according to an embodiment disclosed in this document may be implemented as a module that performs, for example, each function shown in FIG. 2, by being recorded in the memory 620 and processed by the MCU 610.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery diagnosis device, comprising:
a memory configured to store at least one instruction; and
at least one processor configured to execute the at least one instruction,
wherein the at least one processor is configured to:
identify a degradation indicator for each charging capacity of a first battery cell among a plurality of battery cells included in a battery unit;
identify a degradation indicator of a second battery cell based on at least one of a value of a charging capacity of a second battery cell among the plurality of battery cells, a degradation indicator for each charging capacity of the first battery cell, or a combination thereof; and
diagnose a state of the second battery cell based on the degradation indicator of the second battery cell.

2. The battery diagnosis device of claim 1, wherein the one or more processors is configured to identify a value of the degradation indicator of the second battery cell based on a specific value of the degradation indicator of the first battery cell corresponding to the value of the charging capacity of the second battery cell in the degradation indicator for each charging capacity of the first battery cell.

3. The battery diagnosis device of claim 1, wherein the first battery cell includes a battery cell corresponding to the smallest charging capacity among charging capacities of the plurality of battery cells.

4. The battery diagnosis device of claim 1, wherein a charging capacity of each of the plurality of batteries is identified for each battery cell included in the plurality of battery cells based on the number of times of charging and discharging of the battery unit.

5. The battery diagnosis device of claim 4, wherein the charging capacity of each of the plurality of batteries includes a charging capacity according to a state of health (SOH) of each of the plurality of battery cells identified based on the number of times of charging and discharging of the battery unit.

6. The battery diagnosis device of claim 1, wherein the one or more processors is configured to identify the degradation indicator for each charging capacity of the first battery cell based on a constant voltage (CV) charging time, which indicates a duration of a section during which a voltage of the battery unit is held constant during charging or discharging.

7. The battery diagnosis device of claim 1, wherein the battery unit is charged according to a constant current (CC) until a voltage of at least one battery cell among the plurality of battery cells included in the battery unit reaches a reference voltage value, and
the one or more processors is configured to identify the degradation indicator for each charging capacity of the first battery cell based on the fact that the battery unit is charged according to a constant voltage until a current of at least one battery cell among the plurality of battery cells reaches a reference current value after the voltage reaches the reference voltage value.

8. A battery diagnosis method comprising:
an operation of identifying a degradation indicator for each charging capacity of a first battery cell among a plurality of battery cells included in a battery unit;
an operation of identifying a degradation indicator of a second battery cell based on at least one of a value of a charging capacity of a second battery cell among the plurality of battery cells, a degradation indicator for each charging capacity of the first battery cell, or a combination thereof; and
an operation of diagnosing a state of the second battery cell based on the degradation indicator of the second battery cell.

9. The battery diagnosis method of claim 8, wherein the operation of identifying a degradation indicator of a second battery cell based on at least one of a value of a charging capacity of a second battery cell among the plurality of battery cells, a degradation indicator for each charging capacity of the first battery cell, or a combination thereof further includes an operation of identifying a value of the degradation indicator of the second battery cell based on a specific value of the degradation indicator of the first battery cell corresponding to the value of the charging capacity of the second battery cell in the degradation indicator for each charging capacity of the first battery cell.

10. The battery diagnosis method of claim 8, wherein the first battery cell includes a battery cell corresponding to the smallest charging capacity among charging capacities of the plurality of battery cells.

11. The battery diagnosis method of claim 8, wherein a charging capacity of each of the plurality of batteries is identified for each battery cell included in the plurality of battery cells based on the number of times of charging and discharging of the battery unit.

12. The battery diagnosis method of claim 11, wherein the charging capacity of each of the plurality of batteries includes a charging capacity according to a state of health (SOH) of each of the plurality of battery cells identified based on the number of times of charging and discharging of the battery unit.

13. The battery diagnosis method of claim 8, further comprising:
an operation of identifying the degradation indicator for each charging capacity of the first battery cell based on a constant voltage (CV) charging time, which indicates a duration of a section during which a voltage of the battery unit is held constant during charging or discharging.

14. The battery diagnosis method of claim 8, wherein after the battery unit is charged according to a constant current (CC) until a voltage of at least one battery cell among the plurality of battery cells included in the battery unit reaches a reference voltage value, the operation of identifying a degradation indicator for each charging capacity of a first battery cell among a plurality of battery cells included in a battery unit includes an operation of identifying the degradation indicator for each charging capacity of the first battery cell based on the fact that the battery unit is charged according to a constant voltage until a current of at least one battery cell among the plurality of battery cells reaches a reference current value after the voltage reaches the reference voltage value.
